(19) **Europäisches Patentamt / European Patent Office / Office européen des brevets**

(11) **EP 2 104 182 A1**

(12) **EUROPEAN PATENT APPLICATION**

(43) Date of publication:
**23.09.2009 Bulletin 2009/39**

(51) Int Cl.:
*H01Q 21/00* (2006.01)   *H01L 23/00* (2006.01)
*H01L 25/00* (2006.01)

(21) Application number: **08103249.2**

(22) Date of filing: **31.03.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **17.03.2008 US 21652 P**

(71) Applicant: **Raysat, Inc.**
**Vienna, VA 22182 (US)**

(72) Inventors:
• **Barak, Ilan**
  **44335, Kfar Saba (IL)**
• **Marinov, Borislav**
  **Sofia (BG)**
• **Avdjiski, Bojidar**
  **2011, Beli Iskar (BG)**
• **Kostov, Alexander**
  **8000, Bourgas (IL)**

(74) Representative: **Pisani, Diana Jean et al**
**Venner Shipley LLP**
**20 Little Britain**
**London EC1A 7DH (GB)**

(54) **Integrated antenna phased array control device**

(57)   A low cost MMIC based MCM for a fully electronic satellite antenna is implemented in a low cost GaAs optical process coupled to CMOS digitally controlled serial to parallel converters disposed in a low cost ceramic package. External CMOS serial-to-parallel converter chips perform serial - parallel conversion and then transmitting converted data to the GaAs die over, for example, one line per bit - results in a substantially cost reduced system.. Integration of bias circuits inside this module reduce it size and allow easy integration with other parts of the antenna. An architecture allowing the use of minimal number of step attenuators, each having a minimal number of bits, contribute to the small size and low cost.

FIG. 1

**FIG. 9**

**Description**

FIELD OF THE INVENTION

The present invention relates to methods and apparatus for controlling phase and amplitude of signals within a phased array antenna and in particular to methods and apparatus for a miniature, digitally controlled analog microwave signal processing unit in a phased array satellite antenna.

DESCRIPTION OF THE RELATED ART

U.S. Patent 6,545,563 to Smith describes a unit that incorporates a serial to parallel conversion circuit on a GaAs die in order to reduce the number of interconnecting lines. However, this arrangement is disadvantageous in that it requires a large area of the GaAs die in order to implement the serial to parallel converter, thus raising the cost of the GaAs chip and the overall unit. Further, the apparatus of Smith which uses an additional external chip connected via wire bonds to the GaAs analog signal processor requires two wires per control bit, and suffers from a large number of interconnect wires, requiring large area periphery pads on the GaAs, creating high cost and degraded reliability. Various methods and components that address similar problems are known. See, for example, U.S. Patents 7,288,992, 7,262,665, 5,739,723, 6,130,581, 6545563, 6873044, , 5784261, 5,808,515. However, these systems do not adequately address the issues addressed by the present invention.
Accordingly, there is a need for an efficient and reliable GaAs arrangement in a phased array satellite antenna.

SUMMARY OF THE INVENTION

The current invention provides a compact, integrated digital controlled analog signal processor for phased array antennas. In aspects of the invention, circuits (e.g., a signal processor) may provide amplification, phase shift, and metered combining of a multiplicity of receive channels into a single output. The control of these circuits may be variously provided such as by using digital serial line (SPI bus) in order to reduce the wiring complexity of the integrated antenna and the cost of the circuits.
Aspects of the invention may include an integrated antenna phased array control device for use in a phased array scanning antenna. Aspects of the invention enable the use of a small antenna, for example, one having an array area less than about 1600 cm$^2$ for mobile satellite reception of dedicated live TV programs. This is a consumer application, and is therefore cost sensitive.
In still further aspects of the invention, an efficient and cost reduced antenna may be provided using, for example, a low cost GaAs optical process coupled to off-the-shelf digital control serial to parallel converters in a low cost ceramic package. In exemplary embodiments, using use external CMOS serial-to-parallel converter chips to perform the serial parallel conversion and then transmitting converted data to the GaAs die over, for example, using one line per bit - results in a substantially cost reduced system. It also reduces the overall interconnect count while maintaining the economy saving related to using the CMOS analog to digital conversion devices.
The use of high frequency, low noise optical GaAs circuits enables low noise operation while at the same time enabling the unit to function within acceptable parameters even with large manufacturing volumes - thus reducing the overall cost. The cost of the GaAs process is further reduced if the active devices are depeleion mode PHEMT. These devices may be utilized with depletion mode PHEMT devices. In still further embodiments, the circuits may be implemented using alternate technologies such as SiGe BiCMOS technology, that may offer advantageous pricing at the cost of reduced noise performance. In this case, the digital control circuits can be implemented on the same die as the RF devices, thus allowing the implementation of a single die package.
In addition, aspects of the invention may include one or more discrete LNAs and associated bias regulators packaged in, for example, a multi-chip module (MCM).

BRIEF DESCRIPTION OF THE DRAWINGS

The above and other features and advantages of the present invention will become more apparent by describing in detail exemplary embodiments thereof with reference to the attached drawings in which:
FIG. 1 illustrates a first exemplary embodiment of a circuit embodying aspects of the invention for use in an integrated phased array antenna control device.
FIG. 2A schematically illustrates a block diagram of embodiments of the invention for use in the integrated phased array antenna control device of FIG. 1.
FIG. 2B schematically illustrates a circuit for coupling a plurality of control circuits as shown in FIG. 2A in a tandem arrangement.
FIG. 3 illustrates a part schematic part flow diagram of a method of connecting an external LNA device on, for example, a multi-chip module. FIG. 4 illustrates an exemplary response chart for a attenuator in accordance with aspects of the invention.
FIGS. 5-6 illustrate exemplary solid state switches which may be utilized in aspects of the present invention.
FIG. 7 illustrates an exemplary level shifter which may be utilized in aspects of the invention.
FIG. 8 illustrates an exemplary embodiment of a single pole double throw switch.
FIG. 9 is an example of a SiGe BiCOMOS based control device

DETAILED DESCRIPTION OF EXEMPLARY EMBODIMENTS OF THE INVENTION

Hereinafter, exemplary but non-limiting embodiments of the present invention will be described in detail with reference to the accompanying drawings.

Embodiments of the present invention relate to, for example, an integrated antenna phased array control device for use in a phased array scanning antenna. Exemplary embodiments enable the use of small antennas, for example, one having an array area less than about 1600 cm2 for mobile satellite reception of dedicated live TV programs.

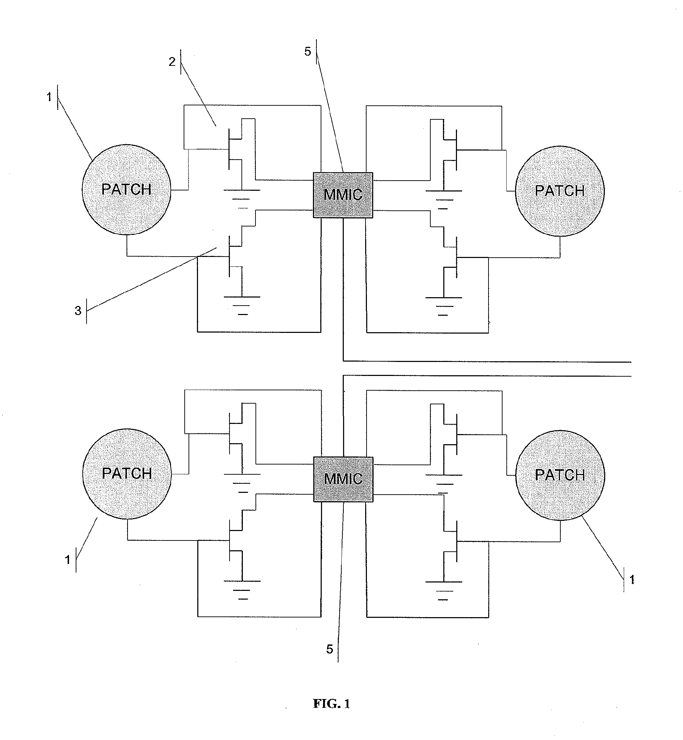

Referring to an exemplary embodiment depicted in FIG. 1, each antenna patch 1 may be variously configured. For example, in the embodiment shown in FIG. 1, each antenna patch produces two signals. In a preferred embodiment, these two signals are two orthogonal signals, for example a horizontally polarized signal and a vertically polarized signal. These signals are typically amplified by a suitable amplification device such as PHEMT devices 2 and 3. In the configuration shown in FIG. 1, the PHEMT devices 2, 3, receive a drain bias from a suitable source such as an input port of an RF integrated control device 5, thus saving an additional feed line as further described below.

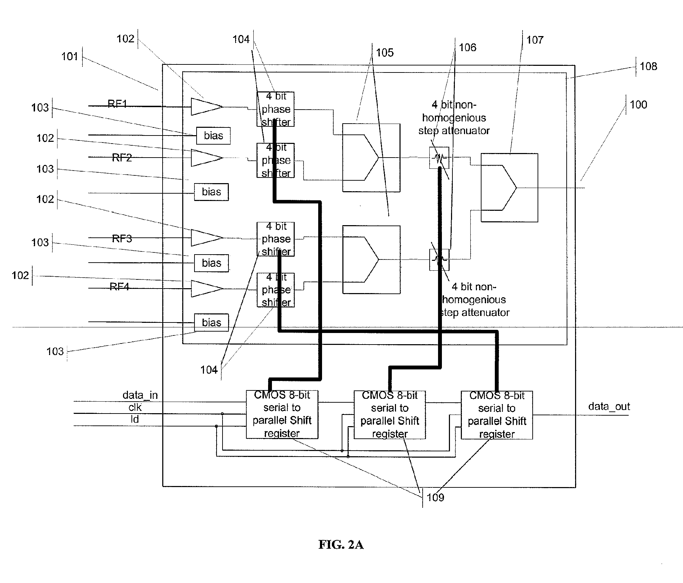

FIG. 2A shows one exemplary embodiment of a multi-chip module 101. The multi-chip module 101 may be variously configured. In one embodiment, it may be configured to accept four input signals which may then be amplified by four LNAs 102. In typical embodiments, two dual polarized antenna patches may be coupled to RF inputs RF1 through RF4. RF1 and RF2 may be coupled to the horizontal polarization ports of the patches. RF3 and RF4 may be coupled to the vertical polarization ports of the patches.

Low Noise Amplifiers 102 may be included to amplify these signals and provide them to, for example, digitally controlled phase shifters 104. The vertical and horizontal signals may be combined respectively in, for example, a power combiner 105. Each polarization (Vertical and Horizontal) signal may be attenuated by a predefined and/or variable amount, for example, using digitally controlled step attenuators 106. The resulting two signals may then be combined in power combiner 107.

In exemplary embodiments, an additional bias control block 103 may be included. This bias control block 103 may control the bias of external LNA stages such as those stages that preamplify the signal before reaching the multi-chip module.

Circuit blocks 102 through 107 are preferably implemented on one GaAs die 108. Serial to parallel shift registers 109 are preferably implemented on one or more separate CMOS chips.

In one exemplary embodiment shown in FIG. 2A, a control circuit comprising digital serial to parallel shift registers 109 are mounted adjacently to the GaAs die 108, and all are situated inside a ceramic package 101. This arrangement allows for a simple control of a multiplicity of phased array control devices typically included in a phased array antenna.

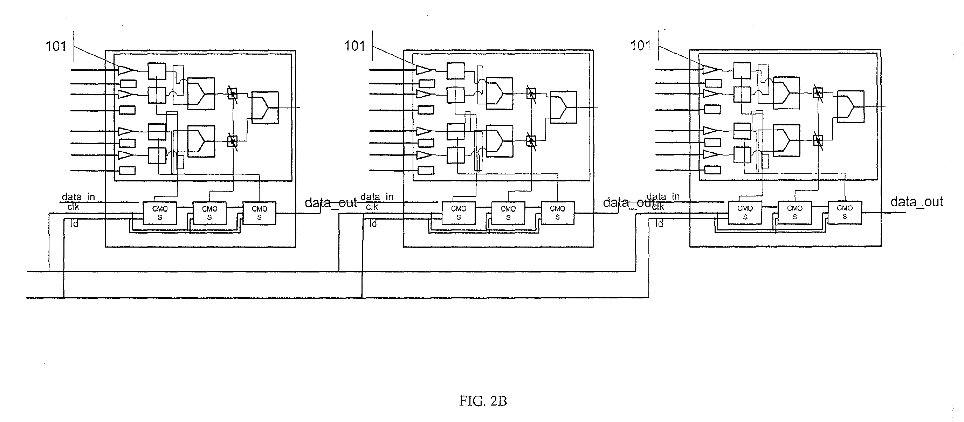

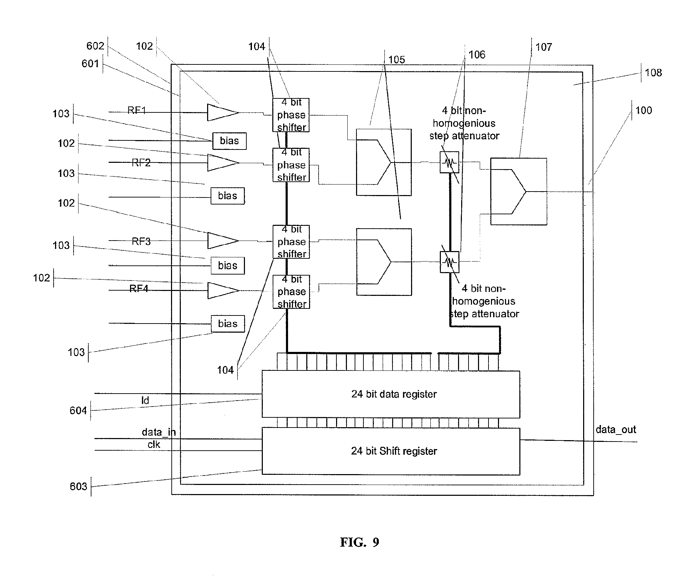

Referring to FIG. 9, in another exemplary embodiment, the control circuit of FIG. 2A may be configured in a tandem connection of control elements. Referring to FIG. 2B, the devices shown in FIG. 2A may be daisy chained together using an interface such as a SPI serial bus controller.

In alternate arrangements, flip chip mounting techniques may be utilized to mount one or more CMOS control devices on the GaAs chip, this facilitating a low noise and simple connection between the control chip and the GaAs chip. In this embodiment, it is advisable to implement the digital and analog functionality needed to control the devices that are on the GaAs die. In one embodiment, the flip device utilizes CMOS technology, in order to lower the total units cost as much as possible.

Again referring to FIG. 1, a signal may be provided to four 4 bit phase shifters 104, which may be configured to have switchable phase shifts of, for example, about 22.4, 45, 90 and 180 degrees. The phase shifters may be configured to carry signals from the horizontal and vertical polarizations in order to be summed respectively by power combiners 105.

The effective polarization inclination, in the case of a linearly polarized signal and equal phase delays in the V and H paths may be described by the equation

$$\varphi = tag^{-1} \frac{E_v}{E_h}$$ where φ is the polarization inclination from the horizontal plane, and Ev and Eh are the signal strength of the vertical and horizontal signals, respectively.

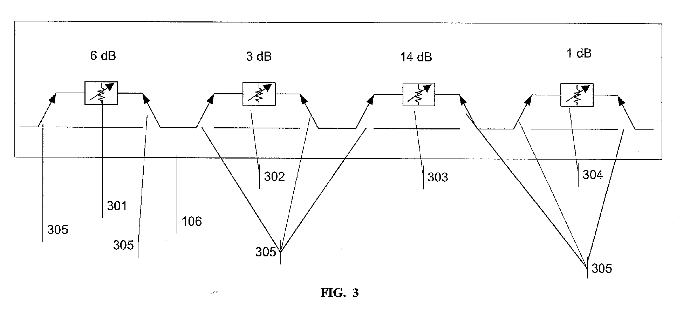

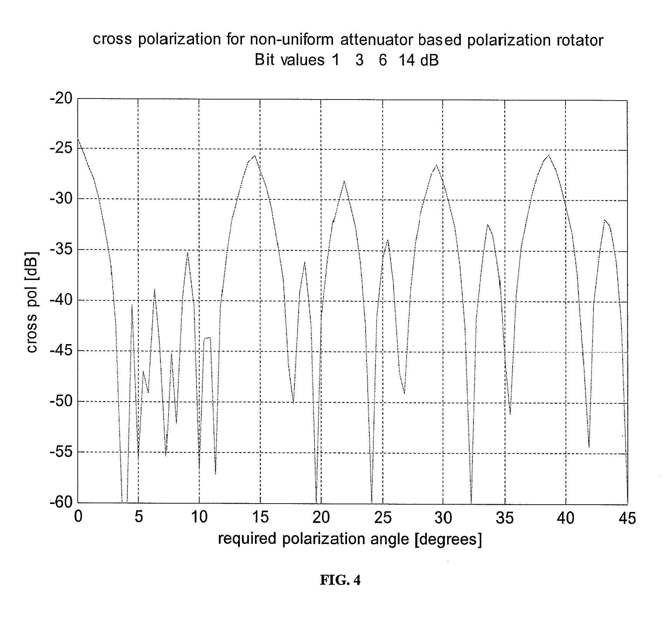

In exemplary embodiments, the inclination is related to the signal level difference. For a non uniform step attenuator such as the one as schematically shown in FIG. 3, attenuation steps of, for example, about 1, 3, 6 and 14 dB may be utilized to produce any inclination with an error less than 24 dB as, for example, shown in FIG 4. This is possible as all the combination of attenuator 1 - attenuator 2 produce 1 dB relative attenuation steps (0,1,2,3,4,5,6.... 24) dB.

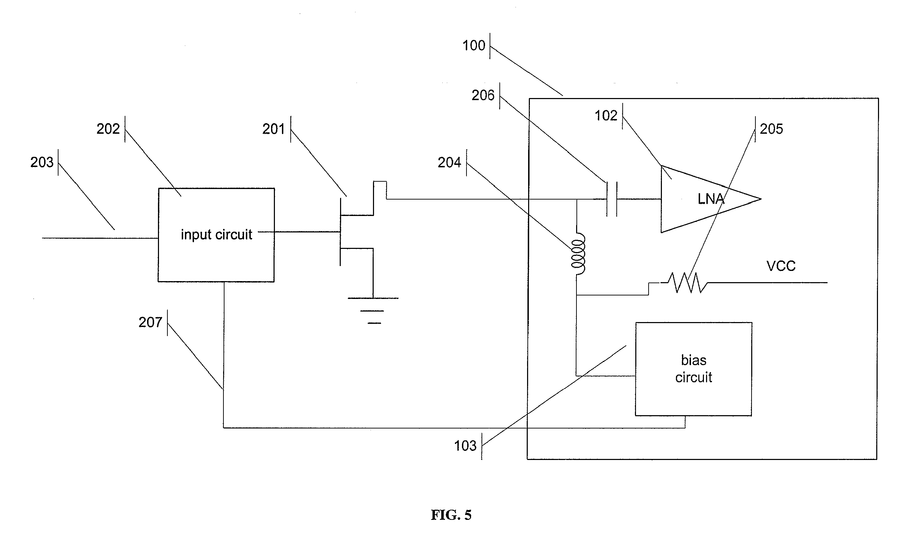

In the case of an antenna intended to receive circular polarizations, it is possible to eliminate the attenuators and feed each LNA input from a circular polarization radiator element. FIG. 5 illustrates an exemplary method of connecting an external LNA device 201 to the multi-chip module 100. The drain current to the device 201 is provided by the bias generator 103, which also provides the gate voltage to the device 201 through a passive input circuit 202. FIG. 4 illustrates the implementation of the step attenuator. Fig 5 illustrates one type of solid state switch which may be used in the design, which typically includes two opposite control voltages.

Still referring to FIG. 5, the Integrated control device may include an external PHEMT with its associated gate voltage. This gate voltage may be controlled in response to the external device drain current. FIG. 5 shows one embodiment of an external discrete LNA PHEMT device connected to the integrated control device. The external device drain current, in this embodiment, is supplied via resistor 205, and bias tee 204, 206. The embodiment has a voltage drop on resistor 205 being proportional to the drain current of PHEMT 201, as monitored by bias control 103. The drain current of PHEMT 201 may be compared to a reference voltage which may then output a gate control voltage on line 207 which may cause the PHEMT device 201 to draw a predetermined constant drain current.

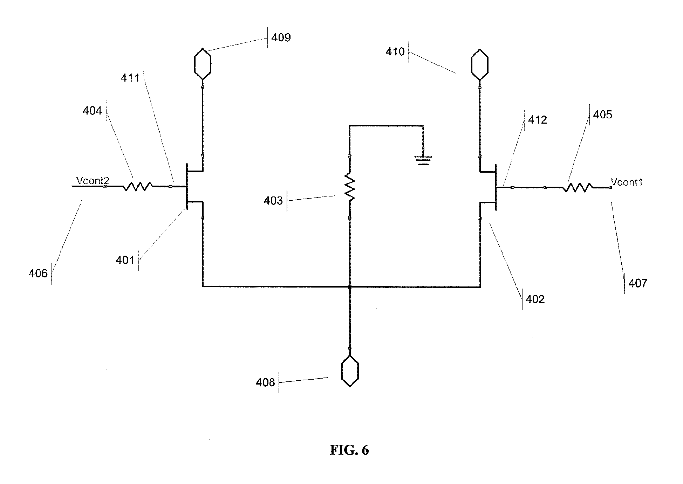

FIG 6 illustrates an alternate solid state switch that utilizes only one control voltage. Referring to FIG 6, an RF input at port 408 can be switched to ports 409 or 410, depending of whether devices 401 or 402 are put into their "on" state, respectively. The control of the on or off state may be performed by providing a small positive voltage around +0.5 V or a negative voltage like - 2.0V respectively to the device gates 411 and 412. It is obvious that such a configuration requires two opposite control voltages. These two opposite voltages are provided by an on-chip logic inverter circuit, which also contains a level shifter.

The phase shifter 104 may be configured to include 4 cascade connected single bit phase shifters. The control of these devices may be variously configured. In one embodiment, the control is predominantly done by SPDT switches and the control elements are PHEMT devices.

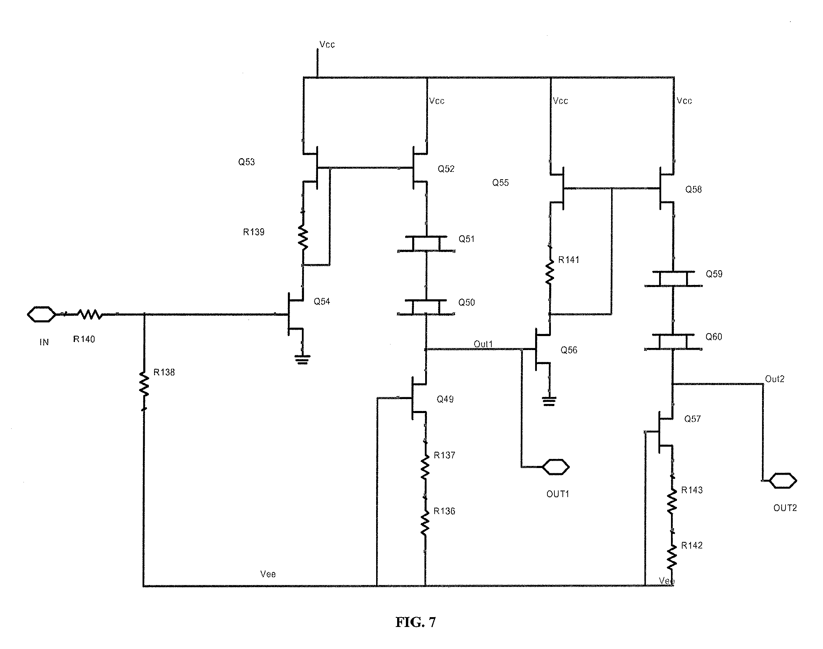

Referring to FIG. 7, there is shown a schematic description of a level shifter and inverter. A 2.5V logic signal may be input on the IN port in order to switch transistor Q54. G52 and the two diodes Q451 and Q50 may be configured to perform level shifting to the required signal levels needed to drive control gates 411. A logic inversion and identical level shifting may be configured to drive the other gate 412 through the OUT2 terminal.

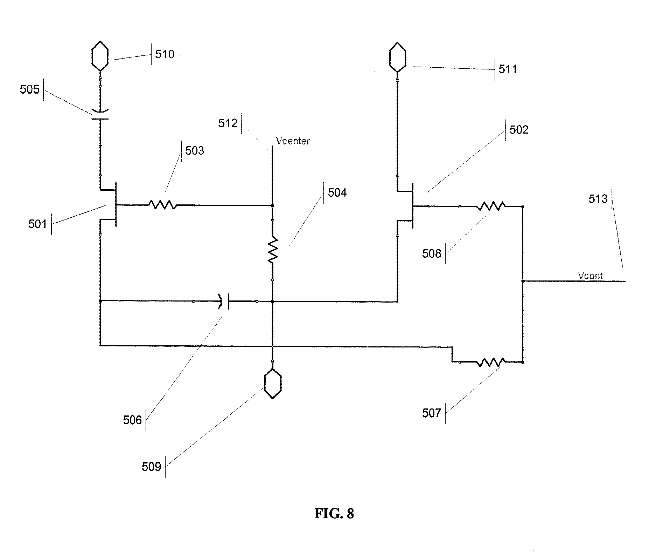

Referring to FIG. 8, an alternate embodiment of the SPDT switch is shown. In this embodiment, a single control voltage is provided to 513, and is used to drive the gate of device 502 and the channel of device 501. The channel of device 502 and the gate of device 501 may be connected to a median voltage Vcenter, such that the control voltage is either higher than Vcenter, and thus turning device 502 on and device 501 off, or lower than Vcenter, thus turning device 502 off and device 501 on.

In an alternate embodiment of the invention, the devices shown in FIG. 1, 2A, 2B, and 3-8 may be implemented using SiGe BiCMOS technology. Figure 9 is an example of such an implementation. These embodiments offer advantageous pricing while only slightly reducing the noise performance. In this case, the digital control circuits can be implemented on the same die as the RF devices, thus allowing the implementation of a single die package. For example, in similar configurations as those discussed with respect to the Figures above, an integrated antenna control device may include a single SiGe BiCMOS die having, 1) digital RF control circuits, 2) one or more digitally controlled phase shifters coupled to the digital RF control circuits, and 3) a plurality of LNAs coupled to the digitally controlled phase shifters.

In still further aspects of the invention, the integrated antenna control device digital RF control circuitry may include one or more serial to parallel converters and one or more digitally controlled step attenuators implemented on the single SiGe BiCMOS die. Figure 9 is an example of such an embodiment. A package 602 include on single die 601 fabricated in SiGe BiCMOS technology. The control of this device is performed by writing 24 consecutive bits into shift register 603 using the data_in line for the data, and the clk line to clock them in. A load command is applied once the writing process is completed, using the Id line. Once data is loaded into the data register 604, the phase shifters and attenuators move to the new written state. In exemplary embodiments, there may be fewer digitally controlled step attenuators than RF inputs and the digitally controlled step attenuators may include steps that are not homogeneous.

In alternate embodiments, the integrated antenna control device may include active bias controllers for controlling discrete LNAs. In this case, the discrete LNAs may be disposed external to the single SiGe BiCMOS die. These embodiments allow for lower noise figure LNAs

The use of at least four phase shifters on the SiGe BiCMOS die permits the handling of two dual polarization radiators, or four circular polarization radiators. This enables the physical placement of this control device adjacent and between these radiators on the same circuit board

**Claims**

1. An integrated antenna control device including:

    a die package;
    one or more GaAs dies mounted inside the die package including a plurality of digitally controlled phase shifters and a plurality of LNAs; and
    one or more silicon dies mounted inside the die package, including one or more shift registers for serial to parallel conversion and being coupled to the one or more GaAs dies.

2. The integrated antenna control device in claim 1, including one or more digitally controlled step attenuators implemented on the GaAs die.

3. The integrated antenna control device as in claim 2, including a plurality of RF inputs, wherein there are fewer digitally controlled step attenuators than RF inputs.

**4.** The integrated antenna control device in claim 3, where the digitally controlled step attenuators include steps that are not homogeneous.

**5.** The integrated antenna control device as in claim 4, where dies are mounted side by side on a common surface, and interconnected with bond wires.

**6.** The integrated antenna control device as in claim 5, where the number of interconnect bond wires between the Si devices and the GaAs devices about equal to the sum of phase shifter and attenuator bits to be controlled.

**7.** The integrated antenna control device as in claim 6, including active bias controllers for controlling discrete LNAs, that are mounted outside of the control device package.

**8.** The integrated antenna control device as in claim7, including four LNAs, four digitally controlled phase shifters, four bias controllers for external LNAs and two digitally controlled step attenuators.

**9.** The integrated antenna control device as in claim 8, where all the GaAs die transistors are depletion mode.

**10.** The integrated antenna control device as in claim 9, where the GaAs die is manufactured in depletion mode PHEMT process.

**11.** The integrated antenna control device as in claim 1, where at least one of the dies is flip-chip mounted on the GaAs die.

**12.** The integrated antenna control device as in claim 11, also including one or more digitally controlled step attenuators implemented on the GaAs die/

**13.** The integrated antenna control device in claim 12, where the digital attenuator steps are not homogeneous.

**14.** The integrated antenna control device as in claim 9, also including internal active bias controllers for external descrete LNAs.

**15.** The integrated antenna control device as in claim 13, where the flip-chip mounted die includes level shifters and digital circuits to perform logic control of the GaAs die.

**16.** An integrated antenna control device including a single SiGe BiCMOS die having,

    1) digital control circuits,
    2) one or more digitally controlled phase shifters coupled to the digital RF control circuits, and
    3) a plurality of LNAs coupled to the digitally controlled phase shifters.

**17.** The integrated antenna control device of claim 16, wherein the digital control circuitry includes a serial to parallel converter.

**18.** The integrated antenna control device as in claim 16, including active bias controllers for controlling discrete LNAs, wherein the discrete LNAs are disposed external to the single SiGe BiCMOS die.

**19.** The integrated antenna control device of claim 18 , including one or more digitally controlled step attenuators

**20.** The integrated antenna control device of claim 19, wherein there are fewer digitally controlled step attenuators than RF inputs.

**21.** The integrated antenna control device in claim 20, where the digitally controlled step attenuators include steps that are not homogeneous.

**22.** The integrated antenna control device as in claim 21, where the number of phase shifters is at least four.

**23.** The integrated antenna control device as in claim 22, including four LNAs, four digitally controlled phase shifters, four bias controllers and two digitally controlled step attenuators.

**FIG. 1**

EP 2 104 182 A1

FIG. 2A

8

FIG. 2B

FIG. 3

cross polarization for non-uniform attenuator based polarization rotator
Bit values 1   3   6   14 dB

FIG. 4

FIG. 5

**FIG. 6**

**FIG. 7**

14

**FIG. 8**

**FIG. 9**

**European Patent Office**

**EUROPEAN SEARCH REPORT**

Application Number

EP 08 10 3249

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 146 593 A (NIPPON ELECTRIC CO [JP]) 17 October 2001 (2001-10-17) * abstract * * page 3, paragraph 23 - paragraph 27 * * page 4, paragraph 33 - paragraph 49 * * figures 1,5,9A-D,10A-D,11D * | 1-15 | INV. H01Q21/00 H01L23/00 H01L25/00 |
| X | US 6 714 768 B2 (LEMPKOWSKI ROBERT [US]) 30 March 2004 (2004-03-30) * abstract * * example 1 * * column 27, line 62 - column 31, line 26; figure 38 * | 1-15 | |
| X | US 4 490 721 A (STOCKTON RONALD J [US] ET AL) 25 December 1984 (1984-12-25) * column 3, line 34 - column 5, line 59 * * column 7, line 19 - column 9, line 36; figures 1-13 * | 1-15 | |
| X | EP 1 318 618 A (TDK CORP [JP]) 11 June 2003 (2003-06-11) * abstract; figures 3,4,11 * | 1-15 | TECHNICAL FIELDS SEARCHED (IPC) H01Q H01L H01P |
| X | US 2005/075080 A1 (ZHANG YUE PING [SG]) 7 April 2005 (2005-04-07) * right-hand column, paragraph 10 - left-hand column, paragraph 18 * * figures 1A,2A,B,4A,B,5A,B * | 1-15 | |
| X | WO 2005/050776 A (CALIFORNIA INST OF TECHN [US]; HASHEMI HOSSEIN [US]; GUAN XIANG [US];) 2 June 2005 (2005-06-02) * abstract * * paragraph [0057] - paragraph [0065]; figure 5 * * paragraph [0081] * | 16-23 | |

-/--

The present search report has been drawn up for all claims

| Place of search | Date of completion of the search | Examiner |
|---|---|---|
| The Hague | 22 August 2008 | Angrabeit, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## European Patent Office

## EUROPEAN SEARCH REPORT

Application Number

EP 08 10 3249

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/146127 A1 (KENT SAMUEL D [US] ET AL KENT III SAMUEL D [US] ET AL) 29 July 2004 (2004-07-29) * abstract * * paragraph [0013] - paragraph [0017] *<br>----- | 16-23 | |

TECHNICAL FIELDS SEARCHED (IPC)

The present search report has been drawn up for all claims

| Place of search | Date of completion of the search | Examiner |
|---|---|---|
| The Hague | 22 August 2008 | Angrabeit, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 10 3249

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2008

| Patent document cited in search report | | Publication date | Patent family member(s) | | Publication date |
|---|---|---|---|---|---|
| EP 1146593 | A | 17-10-2001 | CA | 2356854 A1 | 06-07-2000 |
| | | | WO | 0039892 A1 | 06-07-2000 |
| | | | JP | 3481482 B2 | 22-12-2003 |
| | | | JP | 2000196330 A | 14-07-2000 |
| | | | NO | 20013114 A | 24-08-2001 |
| | | | US | 6556168 B1 | 29-04-2003 |
| US 6714768 | B2 | 30-03-2004 | AU | 2002309978 A1 | 24-02-2003 |
| | | | WO | 03014812 A2 | 20-02-2003 |
| | | | US | 2003027361 A1 | 06-02-2003 |
| US 4490721 | A | 25-12-1984 | NONE | | |
| EP 1318618 | A | 11-06-2003 | US | 2003107517 A1 | 12-06-2003 |
| US 2005075080 | A1 | 07-04-2005 | NONE | | |
| WO 2005050776 | A | 02-06-2005 | EP | 1723726 A2 | 22-11-2006 |
| | | | JP | 2007515104 T | 07-06-2007 |
| US 2004146127 | A1 | 29-07-2004 | AU | 2004207960 A1 | 12-08-2004 |
| | | | CA | 2500533 A1 | 12-08-2004 |
| | | | EP | 1588495 A2 | 26-10-2005 |
| | | | JP | 2006523044 T | 05-10-2006 |
| | | | KR | 20050096163 A | 05-10-2005 |
| | | | WO | 2004068731 A2 | 12-08-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6545563 B, Smith
- US 7288992 B
- US 7262665 B
- US 5739723 A
- US 6130581 A
- US 6873044 B
- US 5784261 A
- US 5808515 A